# EUROPEAN PATENT APPLICATION

(11) **EP 4 579 752 A1**
(43) Date of publication of application: **02.07.2025**
(21) Application number: 23898057.7
(22) Date of filing: 11.10.2023
(51) Int. Cl.: H01L 27/146, G01T 1/24, H01L 31/115, H01L 31/0224, H01L 31/0304, H01L 31/0352

(54) **RADIATION DETECTOR**

(30) Priority: 30.11.2022 KR 20220165022
(71) Applicant: BTOZ Holdings Co., Ltd, Busan 48118 (KR); Shin, Joung Hun, Seoul 07671 (KR)
(72) Inventor: AOKI, Toru, Shizuoka 432-8011 (JP); SHIN, Joung Hun, Seoul 07671 (KR)
(74) Representative: Manitz Finsterwald Patent- und Rechtsanwaltspartnerschaft mbB
(86) International application number: PCT/KR2023/015608
(87) International publication number: WO 2024/117523

(57) **Abstract**

The radiation detector includes a GaN detector array including a plurality of GaN detectors tiled to form a desired array structure, a readout element electrically connected to the GaN detectors, and a base circuit board electrically connected to the readout element.

## Description

### [Technical Field]

The present invention relates to a radiation detector that can be used in a radiation imaging device.

### [Background Art]

Conventional radiation detectors include, for example, CdTe or CZT:CdZnTe single crystals as a conversion layer that responds to radiation. Since these single crystals contain cadmium, a hazardous heavy metal, an alternative single crystal is required.

Gallium nitride (GaN) single crystals were introduced to replace cadmium-based single crystals, and GaN has a large energy band gap like CdTe, making it easy to implement image acquisition methods such as photon counting, and is thus gaining attention as a radiation detector material.

Meanwhile, GaN single crystals are known to have several advantages over CdTe single crystals as a radiation detector material. For example, GaN single crystals have several advantages, such as high resolution and high contrast due to direct conversion, lower energy than CdTe, high sensitivity at about 10 to 30 keV, excellent radiation resistance, stable electrical properties at high temperatures compared to CdTe, high degree of freedom in the manufacturing process, and easy handling due to the hard material properties compared to CdTe.

A technology for implementing a radiation detector using GaN with such excellent properties is required. In particular, when tiling individual GaN detectors to configure a detector with a larger area, a method for reducing the size of the dummy area between the active areas is required. In addition, a GaN detector with reduced noise and easy impedance matching is required.

### <Prior art documents>

- European Patent No. EP2764552 (2019.11.13.)
- US Patent No. US8,405,037 (2013.05.26.)

### [Detailed Description of the Invention]

### [Technical Problem]

The problem to be solved by the present invention is to provide a radiation detector capable of reducing the size of a dummy area between a plurality of tiled GaN detectors and preventing leakage in an edge area.

### [Technical Solution]

A radiation detector according to an embodiment of the present invention includes: a GaN detector array comprising a plurality of GaN detectors tiled to form a desired array structure; a readout element electrically connected to the GaN detectors; and a base circuit board electrically connected to the readout element.

The GaN detector may include an active region including a plurality of pixels for detecting radiation and a barrier region surrounding the active region, and the barrier region may have a size corresponding to one pixel of the GaN detector.

The GaN detector may include a GaN substrate, a nitride semiconductor layer formed on the GaN substrate, a lower electrode formed on a lower side of the GaN substrate, and an upper electrode formed on an upper side of the nitride semiconductor layer. A side surface of the nitride semiconductor layer may include a slanted surface that is inclined at a predetermined angle with respect to a vertical direction.

The predetermined angle may be a value between 8 degrees and 10 degrees.

The GaN detector may include a plurality of pixels for detecting radiation. Each of the plurality of pixels may include a capacitor for storing charges generated by incident radiation, and a transistor connected to the capacitor and acting as a charge-sensitive amplifier.

### [Effect of the Invention]

According to the present invention, the size of the dummy region between a plurality of tiled GaN detectors can be reduced, and leakage current caused by sparks in the edge region can be effectively prevented.

### [Brief Description of the Drawings]

FIG. 1 is a top plan view of a radiation detector according to an embodiment of the present invention.
FIG. 2 is a drawing schematically showing a cross-sectional structure of a radiation detector according to an embodiment of the present invention.
FIG. 3 is a cross-sectional view of a GaN detector of a radiation detector according to an embodiment of the present invention.
FIG. 4 is a drawing showing an example of an internal circuit structure of a pixel of a GaN detector according to an embodiment of the present invention.

### [Embodiments for carrying out the Invention]

Hereinafter, with reference to the attached drawings, embodiments of the present invention will be described in detail so that those skilled in the art can easily implement the present invention. However, the present invention may be implemented in various different forms and is not limited to the described embodiments.

In this specification, when a component is mentioned as being above or below another component, it means that it is directly located above or below the other component, or another component may be interposed between them. In addition, the thickness of the component or layer in the drawings may be exaggerated for easy explanation and understanding. It should be understood that parts indicated by the same drawing reference numerals throughout the specification represent the same component.

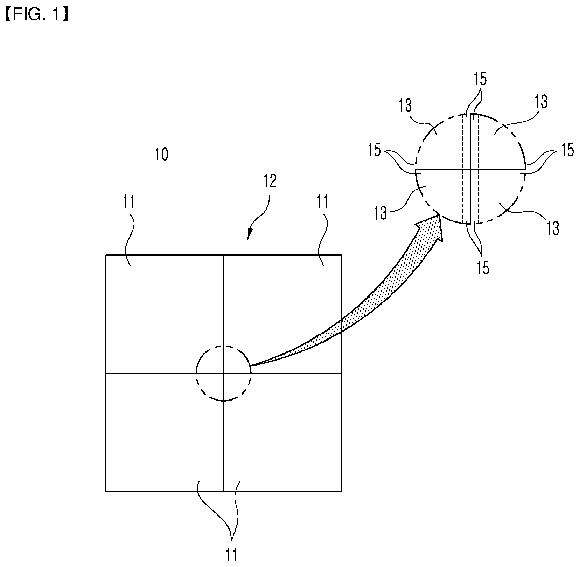

Referring to FIG. 1, a radiation detector 10 according to an embodiment of the present invention includes an array 12 of a plurality of rectangular GaN detectors 11 arranged in a rectangular structure. For example, four GaN detectors 11 may be arranged to form a 2*2 array. FIG. 1 illustrates an example in which an array of four GaN detectors 11 are arranged in a 2*2 structure and tiled to form a rectangular structure, but the number and arrangement form of the GaN detectors may be changed in various ways.

In order to prevent leakage due to sparks generated at the edge when power is applied to operate the GaN detector 11, an insulation region, i.e., a barrier region 13, is provided in the edge region. As shown in the dotted circle of FIG. 1, the GaN detector 11 includes an active region 13 that is a radiation detection region and a barrier region 15 formed around it. The active region 13 may include a plurality of pixels that detect radiation and generate charges, and the barrier region 15 may be formed in the edge region of the GaN detector 11 to surround the active region 13. The barrier region 15 of each GaN detector 11 may be formed to have a size corresponding to one pixel, thereby creating the barrier region 15 corresponding to two pixels between adjacent GaN detectors 11.

In the conventional CdTe detector, a barrier region corresponding to two to three pixels is provided for each detector, and thus a barrier region corresponding to four to six pixels exists between adjacent detectors. On the other hand, in the embodiment of the present invention, since a GaN detector 11 is used as a radiation detector, there is a barrier region corresponding to two narrow pixels compared to a conventional CdTe detector. Since an image is not acquired in the barrier region during radiation imaging, an accurate image cannot be generated by an interpolation operation for generating an image corresponding to the barrier region when a wide barrier region exists, and thus, when a radiation imaging device using a conventional CdTe detector is used, the radiation detector must be moved slightly and then obtain an image again. In contrast, in the radiation imaging device using a GaN detector according to an embodiment of the present invention, since a relatively narrow barrier region corresponding to two pixels exists, an image of the barrier region can be produced with high accuracy by an interpolation operation.

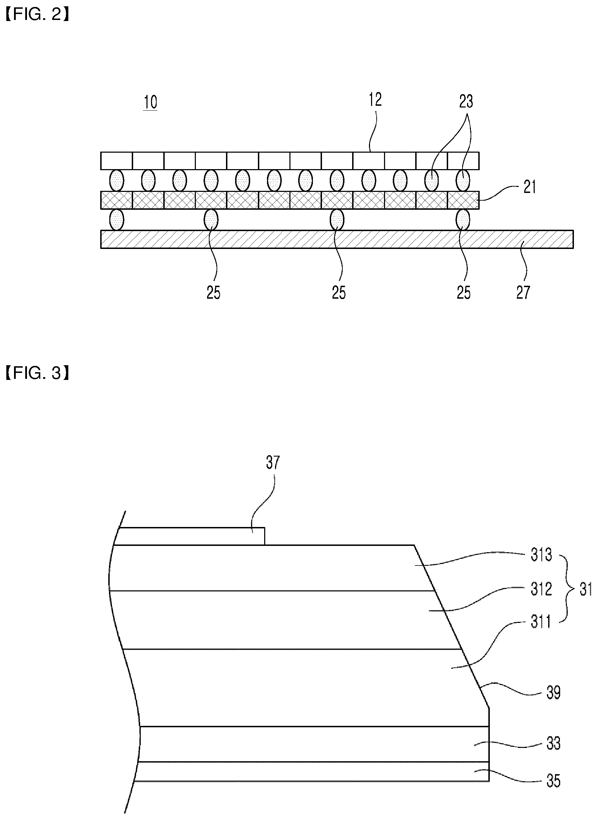

FIG. 2 illustrates a schematic cross-sectional structure of a radiation detector according to an embodiment of the present invention. A read-out element 21, such as an ASIC or other type of read-out chip, is placed under a GaN detector array 12 and is electrically connected to the GaN detector array 12 by an electrically conductive element 23. At this time, the electrically conductive element 23 may be a solder bump formed of an electrically conductive material such as silver. In addition, the read-out element 21 is electrically connected to a base circuit board 27 through an electrically conductive element 25 such as a solder bump. The base circuit board 27 may be implemented as a printed circuit board. The GaN detector 11 may generate an electrical signal corresponding to each pixel by incident radiation such as an X-ray, and the generated electrical signal may be transmitted to the base circuit board 27 through the read-out element 21.

FIG. 3 illustrates a cross-sectional view of a GaN detector 11 according to an embodiment of the present invention. Referring to FIG. 3, a nitride semiconductor layer 31 may be formed on a GaN substrate 33. For example, the nitride semiconductor layer 31 may include a first nitride semiconductor layer 311, a second nitride semiconductor layer 312, and a third nitride semiconductor layer 313 that are sequentially staked on the GaN substrate 33. For example, the nitride semiconductor layer 31 may be formed by a metal organic chemical vapor deposition (MOCVD), a molecular beam epitaxy (MBE), a hydride vapor phase epitaxy (HVPE), or the like.

The first nitride semiconductor layer 311, the second nitride semiconductor layer 312, and the third nitride semiconductor layer 313 may include gallium nitride (GaN). For example, the first nitride semiconductor layer 311 may include n- type gallium nitride, the second nitride semiconductor layer 312 may include p- type gallium nitride, and the third nitride semiconductor layer 313 may include p+ type gallium nitride.

A lower electrode 35 may be formed on the lower side of the GaN substrate 33, and an upper electrode 37 may be formed on the upper side of the nitride semiconductor layer 31. The lower electrode 35 may be a cathode and may be formed, for example, by sputtering or deposition of a metal based on titanium or aluminum. The upper electrode 37 may be an anode and may be formed, for example, by a lift-off process of a metal such as nickel or platinum.

In order to prevent avalanche breakdown due to electric field concentration that may occur at the edge region of the GaN detector 11, an inclined surface 39 is formed on the side surface of the nitride semiconductor layer 31. The inclined surface 39 may be formed over the entire nitride semiconductor layers 311, 312 and 313 consisting of the nitride semiconductor layer 31 as shown in FIG. 3, or may be formed only in a part thereof. For example, the inclined surface 39 may be formed by a mesa etching process. The inclined surface 39 may be formed to form an angle of 8 to 10 degrees with respect to the vertical direction, and this range is appropriate when used as a radiation detector that uses a bias voltage of approximately 100 to 500 V.

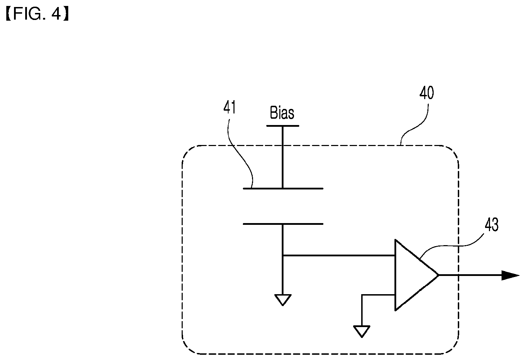

FIG. 4 is a diagram showing the circuit structure of a pixel 40 of a GaN detector 11 according to an embodiment of the present invention. Referring to FIG. 4, a capacitor 41 for storing charges generated by radiation incidence and a transistor 43 connected to the capacitor 41 and acting as a charge sensitive amplifier may be provided in each pixel, thereby improving the signal-to-noise performance of the detector. The capacitor 41 and the transistor 43 may be formed through the same manufacturing process.

Although the embodiments of the present invention have been described above, the scope of the present invention is not limited thereto, and includes all changes and modifications that can be easily modified and deemed equivalent by a person having ordinary skill in the art to which the present invention pertains from the embodiments of the present invention.

### [Industrial Applicability]

The present invention relates to a radiation detector and has an industrial applicability.

## Claims

1. A radiation detector comprising:
a GaN detector array comprising a plurality of GaN detectors tiled to form a desired array structure;
a readout element electrically connected to the GaN detectors; and
a base circuit board electrically connected to the readout element.

2. The radiation detector of claim 1, wherein the GaN detector comprises an active region including a plurality of pixels for detecting radiation, and a barrier region surrounding the active region, and
wherein the barrier region has a size corresponding to one pixel of the GaN detector.

3. The radiation detector of claim 1, wherein the GaN detector comprises a GaN substrate, a nitride semiconductor layer formed on the GaN substrate, a lower electrode formed on a lower side of the GaN substrate, and an upper electrode formed on an upper side of the nitride semiconductor layer, and
wherein a side surface of the nitride semiconductor layer comprises a slanted surface that is inclined at a predetermined angle with respect to a vertical direction.

4. The radiation detector of claim 3, wherein the predetermined angle is a value between 8 degrees and 10 degrees.

5. The radiation detector of claim 1, wherein the GaN detector comprises a plurality of pixels for detecting radiation, and
wherein each of the plurality of pixels comprises a capacitor for storing charges generated by incident radiation, and a transistor connected to the capacitor and acting as a charge-sensitive amplifier.
